# DEMANDE DE BREVET EUROPEEN

(11) **EP 4 376 054 A1**
(43) Date de publication de la demande: **29.05.2024**
(21) Numéro de dépôt: 22209151.4
(22) Date de dépôt: 23.11.2022
(51) Int. Cl.: H01L 21/285, H01L 29/45

(54) **PROCÉDÉ DE RÉALISATION D'UN CIRCUIT INTÉGRÉ POUR PALLIER DES DÉFAUTS OU DES DISLOCATIONS**

(71) Demandeur: EM Microelectronic-Marin SA, 2074 Marin (CH)
(72) Inventeur: JACQUEMIN, Jean-Philippe, 25300 DOUBS (FR); LOLIVIER, Jérôme, 1400 Yverdon-les-bains (CH); MEYER, René, 2525 Le Landeron (CH)
(74) Mandataire: ICB SA

(57) **Abrégé**

Le procédé permet de réalisation un circuit intégré sans défauts ou dislocations au terme du procédé. Sur un substrat en silicium (1), il est déposé initialement une première couche (2) d'un composant chimique métallique. Sur cette première couche, il est déposé ensuite une couche de protection (3) constituée d'un composant chimique principal différent du composant chimique principal de la première couche. Une couche supplémentaire (4) est encore déposée sur la couche de protection. Cette couche supplémentaire comprend un composant chimique principal différent ou équivalent ou de dimension équivalente au composant chimique principal de la première couche. Dans une étape suivante du procédé, il est effectué une opération de traitement thermique à une première température définie pour générer un siliciure (2', 2") constitué du composant principal de la première couche et du silicium selon une première stoechiométrie. Dans une étape suivante du procédé, il est effectué le retrait de la couche supplémentaire, et de la couche de protection par une opération de gravure humide. Dans une ultime étape du procédé, il est effectué une autre opération de traitement thermique à une température définie plus élevée que la première température afin de changer la stoechiométrie du siliciure précédemment créé.

## Description

### Champ de l'invention

La présente invention fait référence à un procédé de réalisation (fabrication) d'un circuit intégré afin de pallier des défauts ou des dislocations pouvant survenir au cours du procédé.

### Etat de la technique

Il est connu durant la réalisation de circuits intégrés de réduire les risques de délaminations. A ce titre, il est effectué un empilement de couches de telle manière à éviter de faire des trous aux interfaces des couches empilées.

Le document US 7,129,169 B2 décrit justement un procédé de réalisation d'un circuit intégré avec un empilement de couches qui a pour but d'éviter de faire des trous lors de l'empilement des différentes couches et dans le but d'éviter les risques de délaminations. Plus précisément, il est recherché de former un contact métallique sur le substrat d'un circuit intégré avec la formation d'une couche métallique réfractaire sur le substrat, qui comprend une zone active et non active, et la formation d'une couche de protection sur la couche métallique réfractaire. Il est encore réalisé une couche de contre réaction choisie à partir d'un matériau tel qu'une contrainte directionnelle opposée est créée entre la couche de contre réaction et la couche de couverture, par rapport à une contrainte directionnelle créée entre la couche de métal réfractaire et la couche de couverture.

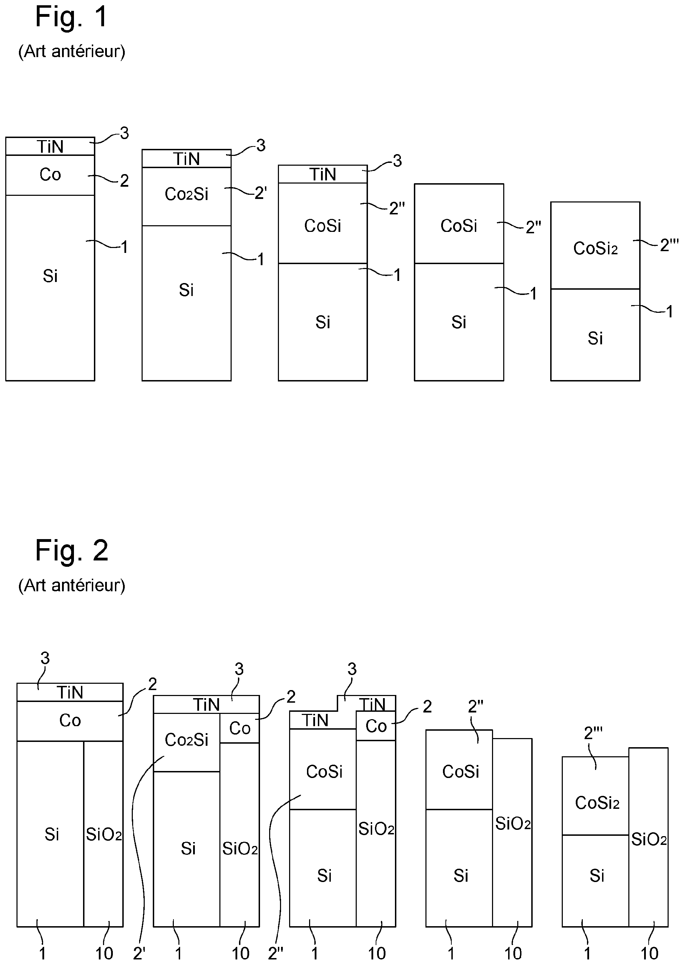

La figure 1 représente les différentes étapes selon une première variante d'un procédé de réalisation d'un circuit intégré et notamment pour la réalisation de contacts électriques sur un substrat semi-conducteur 1, qui est de préférence du Silicium, du circuit intégré pour la connexion électrique avec des composants électroniques externes ou par contact direct.

Bien entendu, la représentation des différentes couches au-dessus du substrat est représentée de manière simplifiée uniquement pour comprendre l'agencement de ces différentes couches au cours du procédé. La forme du substrat est également simplifiée, car généralement un tel substrat de silicium 1 se présente sous la forme d'une plaquette circulaire. Cette plaquette circulaire peut être de diamètre de l'ordre de 20 cm (8 inches) à 30 cm (12 inches) et d'une épaisseur d'environ 750 µm. Cependant, il peut être imaginé également d'avoir des plaquettes de silicium sous forme rectangulaire.

Initialement sur au moins une face supérieure du substrat semi-conducteur 1 du circuit intégré à réaliser, il est disposé au moins une première couche 2 d'un composant chimique métallique, qui peut être du cobalt.

Ainsi, une première étape préliminaire du procédé consiste à déposer par exemple sur la face supérieure du substrat semi-conducteur en silicium une première couche 2 qui peut être métallique dès son dépôt sur la face supérieure ou devenir conductrice par dopage réalisé depuis la surface supérieure du substrat semi-conducteur. Dans cette première étape de réalisation, il est déposé une première couche 2 d'un composant métallique par exemple le cobalt. Le dépôt de cette couche de cobalt peut être réalisé par un dépôt PVD. Au-dessus de cette première couche de cobalt, il est déposé une couche de protection 3 par exemple une couche de nitrure de titane (TiN), qui fait office de barrière de diffusion.

Dans une seconde étape du procédé de réalisation du circuit intégré, il est effectué une opération de traitement thermique (chauffage) qui est l'étape RTA1. Cette opération de traitement thermique peut être de l'ordre de 500°C, mais au moins 350°C pour modifier au moins la première couche ici de cobalt pour passer du cobalt au siliciure de cobalt qui peut être avec différentes stoechiométries. Dans ce cas de figure de la deuxième étape du procédé, il s'agit de la réalisation d'un siliciure de cobalt 2' qui est composé de deux atomes de cobalt pour un atome de silicium (Co₂Si). On remarque bien entendu qu'une partie du silicium du substrat est prélevée pour la réalisation de ce siliciure de cobalt. Lors de cette opération déjà il peut survenir dans le réseau des lacunes voire des défauts ou dislocations, qui peuvent être provoqués par l'intermédiaire de la couche de protection en nitrure de titane dont la dimension des atomes est différente de ceux de la première couche modifiée.

Il peut bien évidemment être effectué une troisième étape de procédé de réalisation du circuit intégré avec un nouveau traitement thermique à l'image de la seconde étape et dans laquelle une portion de silicium est encore combinée ou diffusée dans la première couche en liaison aux atomes de cobalt. Dans ce cas de figure, le siliciure de cobalt 2" peut comprendre un atome de cobalt et un atome de silicium (CoSi). Les étapes deux et trois se déroulent habituellement lors d'un seul traitement thermique à une température supérieure à 375°C et inférieure à 550°C.

Dans une quatrième étape du procédé de réalisation du circuit intégré, la couche de protection en nitrure de titane est retirée par une opération de gravure humide. Finalement, une cinquième étape RTA2 est effectuée avec un autre traitement thermique pouvant aller jusqu'à 750°C de manière à faire passer le siliciure de cobalt 2'" à un atome de cobalt lié à deux atomes de silicium (CoSi₂), avec une partie du silicium diffusé dans la première couche de cobalt.

On constate qu'avec ce procédé de réalisation du circuit intégré selon l'art antérieur, il peut survenir au cours du procédé des défauts et des dislocations du réseau au niveau du silicium principalement. Ces défauts peuvent ensuite ségréger et donc nuire ensuite à la qualité de la connexion électrique entre le semi-conducteur et le circuit électronique.

La figure 2 représente les différentes étapes selon une seconde variante du procédé de réalisation d'un circuit intégré. Dans cette seconde variante, il y a en parallèle une portion 10 de substrat en oxyde de silicium (SiO₂) en liaison au substrat silicium. Sinon toutes les étapes décrites en référence à la figure 1 sont également effectuées pour la seconde variante de la figure 2. Mais dans ce cas de figure, la couche 10 d'oxyde de silicium n'est absolument pas affectée par toutes les étapes du procédé de réalisation du circuit intégré. Cela signifie que la couche 10 d'oxyde de silicium garde une même épaisseur tout au long du procédé de réalisation du circuit intégré. Par contre à la quatrième étape du procédé, il doit être retiré au-dessus de la couche d'oxyde de silicium en plus de la couche de nitrure de titane, une portion de couche 2 de cobalt. Mais au terme de la cinquième étape du procédé, il faut encore réaliser l'opération de traitement thermique comme la cinquième étape décrite en référence à la figure 1.

On constate qu'avec ce procédé de réalisation du circuit intégré selon l'art antérieur, il est constaté des défauts et des dislocations du réseau au niveau principalement du silicium. Cela peut nuire à la qualité de la couche de siliciure de cobalt pour obtenir une bonne couche de contact afin d'effectuer une connexion avec un circuit électronique externe par exemple.

### Résumé de l'invention

La présente invention a pour but de réaliser au moins un circuit intégré sur un substrat semi-conducteur en silicium avec un empilement de couches prévues pour éliminer les dislocations ou défauts dans ou sur le substrat durant le procédé de réalisation du circuit intégré. De préférence, la présente invention est relative à la réalisation d'un circuit intégré avec des composants chimiques de dimensions différentes et de comportements différents dans les différentes étapes de fabrication tout en évitant d'avoir des défauts ou dislocations aux termes du procédé de réalisation du circuit intégré.

Pour ce faire, le procédé de réalisation d'un circuit intégré comprend les caractéristiques définies dans la revendication indépendante 1.

Des étapes particulières de réalisation du circuit intégré sont définies dans les revendications dépendantes 2 à 10.

Un avantage du procédé de réalisation d'un circuit intégré de la présente invention réside dans le fait qu'au terme des étapes de fabrication, le circuit intégré est protégé de toute dislocation ou défaut.

Avantageusement, il est déposé initialement une première couche d'un composant chimique métallique sur une face du substrat silicium. Une couche de protection en tant que barrière de diffusion, est ensuite déposée sur la première couche. Cette couche de protection est constituée d'un composant chimique principal différent du composant chimique principal de la première couche. Une couche supplémentaire est encore déposée sur la couche de protection. Cette couche supplémentaire comprend un composant chimique principal différent ou équivalent ou de dimension équivalente au composant chimique principal de la première couche. De préférence, le composant chimique principal de la couche supplémentaire est de dimension équivalente à celle du composant principal de la première couche, et il peut s'agir par exemple du même composant chimique métallique principal.

Avantageusement, il est effectué une siliciuration pour permettre d'assurer une bonne continuité électrique entre tout contact et la partie active. Le composant de base est une plaquette ou substrat de silicium sur lequel peut être déposée une première couche de cobalt par exemple par le procédé PVD. Au-dessus de cette première couche de cobalt il y a un dépôt d'une couche de nitrure de titane qui est très dure et fait office de barrière de diffusion.

Avantageusement, dans les premières étapes de réalisation il est ajouté encore dès le début du procédé de réalisation du circuit intégré, une couche supplémentaire sur la couche de protection, qui peut être une couche de nitrure de titane de manière à compenser les effets de tension entre des composants chimiques des couches précédentes. On peut parler d'un balancement des contraintes entre ces différentes couches de telle manière à éviter la génération de défauts ou dislocations dans ledit réseau au terme du procédé de réalisation du circuit intégré. Cette couche supplémentaire ajoutée peut comprendre un composant chimique principal différent ou équivalent au composant chimique métallique principal de la première couche. De préférence il peut s'agir du composant chimique principal qui est le cobalt, si la première couche comprend du cobalt.

Avantageusement, dans une étape suivante de fabrication, une couche de siliciure de cobalt (Co₂Si) selon une première stoechiométrie, est obtenue, en dessous de la couche de protection TiN disposée sur cette couche de siliciure de cobalt. Cette couche de protection en nitrure de titane comprend des composés chimiques notamment le titane, qui est de dimension différente à celle du cobalt. Dans ces conditions, il peut survenir si aucune protection supplémentaire n'est prévue dans des étapes subséquentes du procédé, l'apparition d'éventuels défauts ou dislocations du réseau. C'est pourquoi, il est prévu de déposer au-dessus de la couche de nitrure de titane dès le début du procédé, une couche supplémentaire, qui est composée d'au moins un composé chimique de dimension différente ou équivalente à celui de la première couche de cobalt initialement ou de siliciure de cobalt. Comme indiqué ci-dessus, le composant chimique principal de la couche supplémentaire peut être du cobalt comme la première couche.

Au terme du procédé de fabrication du circuit intégré, la couche supplémentaire et la couche de nitrure de titane sont retirées ainsi que la couche de cobalt si existante encore. Il ne reste au final que la couche de siliciure de cobalt réalisée sur le substrat silicium selon une seconde stoechiométrie. Grâce à la couche supplémentaire ajoutée durant le procédé de fabrication, il est constaté en fin de fabrication qu'aucun défaut ou dislocation n'est survenu au terme du procédé. De plus étant donné que la couche supplémentaire et la couche de nitrure de titane ont été retirées il n'est pas possible de déduire la manière dont a été réalisé le circuit intégré sans défauts et sans dislocations.

### Brève description des dessins

Les buts, avantages et caractéristiques du procédé de réalisation d'un circuit intégré pour pallier des défauts ou des dislocations apparaîtront mieux dans la description suivante de manière non limitative en regard des dessins sur lesquels :
Figure 1 représente de manière simplifiée les différentes étapes d'une première variante du procédé de réalisation d'un circuit intégré selon l'art antérieur,
Figure 2 représente de manière simplifiée les différentes étapes d'une seconde variante du procédé de réalisation d'un circuit intégré selon l'art antérieur, qui se base sur des étapes de réalisation similaires à celles décrites pour la Figure 1,

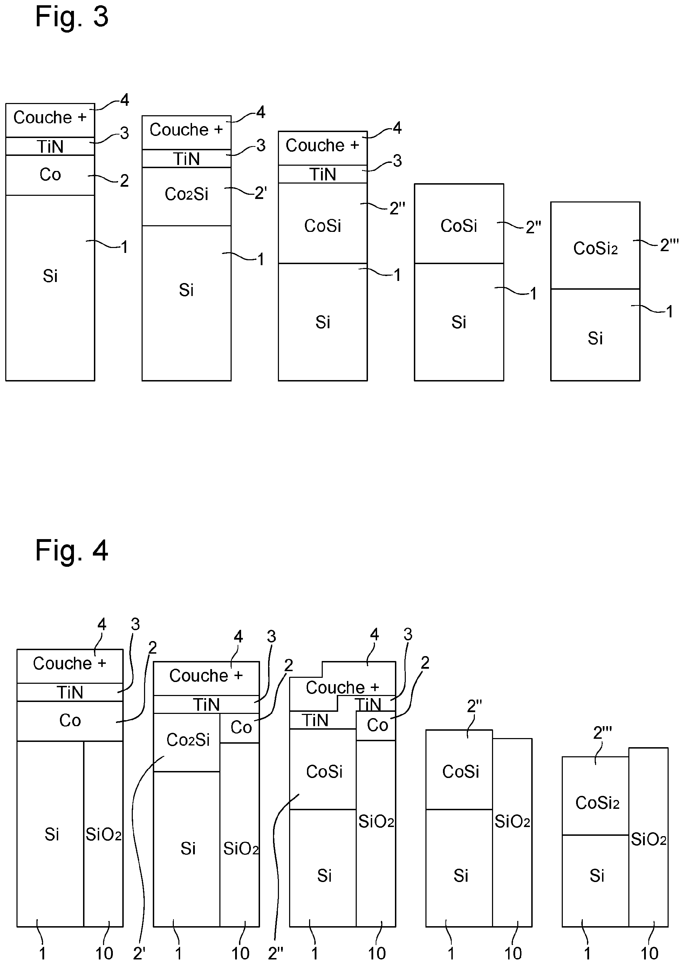

Figure 3 représente de manière simplifiée les différentes étapes d'une première variante du procédé de réalisation d'un circuit intégré selon la présente invention, qui comprend une couche supplémentaire disposée sur une couche de protection avec des étapes de réalisation décrites en partie en référence à la figure 1 pour pallier des dislocations ou des défauts pouvant survenir au cours du procédé,
Figure 4 représente de manière simplifiée les différentes étapes d'une seconde variante du procédé de réalisation d'un circuit intégré selon la présente invention, qui comprend une couche supplémentaire disposée sur une couche de protection avec des étapes de réalisation décrites en partie en référence à la figure 2 pour pallier des dislocations ou des défauts pouvant survenir au cours du procédé,

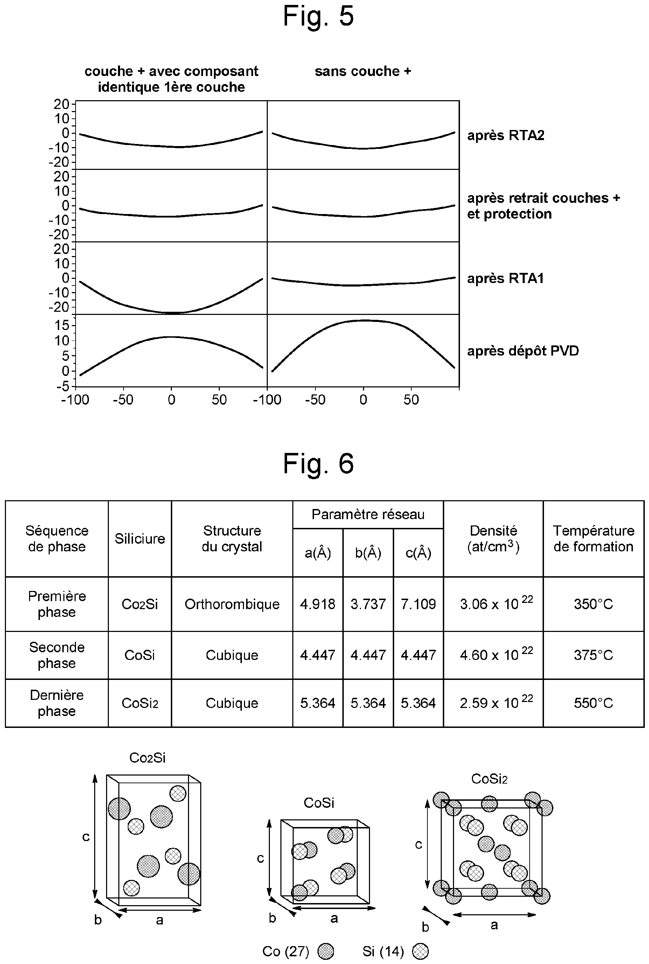

Figure 5 représente un tableau comparatif du procédé de réalisation d'un circuit intégré selon l'art antérieur, par rapport au procédé de réalisation d'un circuit intégré selon la présente invention pour laquelle une couche supplémentaire est ajoutée sur une couche de protection depuis le début du procédé de réalisation, et
Figure 6 représente un tableau de structure de la première couche au cours du procédé selon trois étapes essentielles du procédé de réalisation d'un circuit intégré selon la présente invention concernant principalement la première couche de siliciure de cobalt avec différentes stoechiométries.

### Description détaillée de l'invention

Dans la description suivante, le circuit intégré est réalisé normalement sur une base ou plaquette ou substrat semi-conducteur de silicium. De préférence, il est décrit un procédé de réalisation ou fabrication du circuit intégré de manière par exemple à réaliser des couches ou plages de contact électrique pour lier des composants électroniques externes ou disposés en contact direct avec le circuit intégré réalisé.

La figure 3 représente les différentes étapes selon une première variante d'un procédé de réalisation d'un circuit intégré sans défauts ou dislocations au terme du procédé. Il peut être cherché avec ce procédé de réaliser ou fabriquer au moins des contacts électriques sur le substrat semi-conducteur en silicium 1 du circuit intégré pour la connexion électrique avec des composants électroniques externes ou par contact direct. Cependant, il peut encore être envisagé de réaliser des portions conductrices d'électricité pour la connexion de différents composants électroniques réalisés sur ou dans le circuit intégré, ou d'autres parties du circuit intégré.

Bien entendu, la représentation des différentes couches au-dessus du substrat silicium 1 est représentée de manière simplifiée uniquement pour comprendre l'agencement de ces différentes couches au cours du procédé comme expliqué au paragraphe [0005] ci-dessus.

Initialement dans une étape préliminaire ou une première étape du procédé sur au moins une face supérieure du substrat semi-conducteur 1 du circuit intégré à réaliser, il est déposé au moins une première couche 2 d'un composant chimique métallique, qui peut être du cobalt qui est un bon conducteur électrique, voire également d'autres composants chimiques métalliques comme le titane ou le nickel. Cette première couche métallique 2 peut aussi devenir conductrice par dopage réalisé depuis la surface supérieure du substrat semi-conducteur en silicium 1.

Le dépôt de cette première couche métallique 2, telle que le cobalt peut être réalisé par un dépôt PVD. Au-dessus de cette première couche 2 de cobalt, il est déposé une couche de protection 3, qui fait office de barrière de diffusion. Il peut s'agir par exemple d'une couche de nitrure de titane (TiN). De plus selon la présente invention, il est encore déposé une couche supplémentaire 4 sur la couche de protection 3 de manière à compenser différents stress lors des étapes du procédé de réalisation. Cette couche supplémentaire 4 est constituée d'un composant chimique principal différent ou équivalent ou de dimension équivalente du composant chimique métallique principal de la première couche 2. Dans le cas d'une première couche composée de cobalt, la couche supplémentaire 4 peut comprendre comme composant chimique principal également du cobalt. C'est avant tout avec cette configuration là qu'il est possible d'arriver au terme du procédé sans défauts ou dislocations du réseau du circuit intégré.

Dans une seconde étape du procédé de réalisation du circuit intégré, il est effectué une opération de traitement thermique (chauffage) qui est une étape définie RTA1. Cette opération de traitement thermique est effectuée à une température définie pour générer un siliciure 2' constitué du composant principal de la première couche 2 et du silicium 1 selon une première stoechiométrie. Dans le cas où la première couche est composée de cobalt, cette première opération de traitement thermique permet d'obtenir le siliciure de cobalt 2' selon une première stoechiométrie, c'est-à-dire avec deux atomes de cobalt liés à un atome de silicium (Co₂Si).

Cette opération de traitement thermique peut être de l'ordre de 500°C, mais au moins 350°C pour modifier au moins la première couche ici de cobalt pour passer du cobalt au siliciure de cobalt qui peut être avec différentes stoechiométries. On remarque bien entendu qu'une partie du silicium du substrat est prélevée pour la réalisation de ce siliciure de cobalt.

Il peut bien évidemment être effectué ou non une troisième étape de procédé de réalisation du circuit intégré avec un nouveau traitement thermique à une température équivalente ou différente ou supérieure de celle de la seconde étape du procédé. A l'image de la seconde étape, il est réalisé un autre siliciure constitué du composant principal de la première couche 2 et du silicium 1, ou une portion de silicium est encore combinée ou diffusée dans la première couche en liaison aux atomes de cobalt. Dans ce cas de figure si le composant principal de la première couche 2 est le cobalt, il s'agira du siliciure de cobalt 2", qui peut comprendre un atome de cobalt et un atome de silicium (CoSi) selon une seconde stoechiométrie.

Il est à noter que généralement les siliciures de Cobalt 2' et 2" sont créés consécutivement lors de la première siliciuration RTA1 à une température >400°C et <550°C regroupant les seconde et troisième étapes.

Dans une quatrième étape du procédé de réalisation du circuit intégré ou dans une étape suivante de la seconde étape, la couche de protection 3 ainsi que la couche supplémentaire 4 sont retirées par une opération de gravure humide. Finalement, dans une cinquième ou ultime étape du procédé définie RTA2, il est effectué une autre opération de traitement thermique à une température plus élevée que la première température afin de changer la stoechiométrie du siliciure précédemment créé, c'est-à-dire de siliciure constitué du composant principal de la première couche 2 et du silicium 1. Dans le cas du cobalt, il s'agira du siliciure de cobalt 2'" avec un atome de cobalt lié à deux atomes de silicium (CoSi₂), si la troisième étape du procédé a été effectuée et selon une troisième stoechiométrie.

Dans le cas du cobalt, la première température de traitement thermique RTA1 pour réaliser le siliciure de cobalt est au moins de 400°C et peut aller jusqu'à 500°C pour créer le siliciure 2". La température de la dernière étape de siliciuration du dernier traitement thermique RTA2 peut être fixée à 550°C, et peut aller même jusqu'à 750°C. Cette siliciuration peut être effectuée sur d'autres composants chimiques métalliques, et il peut s'agir également du nickel ou du titane ou d'un autre matériau métallique susceptible de pouvoir subir une siliciuration. Dans ce cas, les températures de siliciuration devront être adaptées.

Après avoir retiré la couche supplémentaire 4 et la couche de protection de nitrure de titane au moyen d'une gravure humide, il ne reste plus que la dernière étape du procédé de réalisation du circuit intégré avec le traitement thermique indiqué ci-dessus à une température supérieure à 550°C. Le siliciure de cobalt se trouve selon une troisième stoechiométrie si le procédé compte toutes les étapes indiquées ci-dessus. On peut ainsi constater au terme du procédé comme la couche supplémentaire et la couche de nitrure de titane ont été retirées par gravure humide, que la manière de réaliser le circuit intégré sans défauts et sans dislocations et rendue invisible, car il n'est pas possible de savoir quel procédé a été utilisé pour éviter ce problème de défauts de dislocations.

La figure 4 représente les différentes étapes selon une seconde variante du procédé de réalisation d'un circuit intégré selon la présente invention. Dans cette seconde variante, il y a en parallèle une portion 10 de substrat en oxyde de silicium (SiO₂) en liaison au substrat silicium. Sinon toutes les étapes décrites en référence à la figure 3 sont également effectuées pour la seconde variante de la figure 4. Cependant, la couche 10 d'oxyde de silicium n'est absolument pas affectée par toutes les étapes du procédé de réalisation du circuit intégré. Cela signifie que la couche 10 d'oxyde de silicium garde une même épaisseur tout au long du procédé de réalisation du circuit intégré. Par contre à la quatrième étape du procédé, il doit être retiré au-dessus de la couche d'oxyde de silicium en plus de la couche supplémentaire 4 et de la couche de protection 3 de nitrure de titane, il faut encore retirer une portion de la première couche 2 de cobalt. Au terme de la cinquième ou ultime étape du procédé, il faut encore réaliser l'opération de traitement thermique comme la cinquième étape décrite en référence à la figure 3.

La figure 5 représente uniquement un comparatif entre le procédé de réalisation du circuit intégré selon la présente invention du côté gauche et selon l'art antérieur du côté droite du tableau. Il est montré principalement au niveau de la seconde et/ou troisième étape du procédé lors du premier traitement thermique avec siliciuration de la première couche de cobalt et de silicium, qu'une compression est plus importante grâce à la couche de protection sur laquelle est disposée la couche supplémentaire agissant dans le but d'éviter la génération de défauts ou de dislocations durant le procédé de fabrication du circuit intégré.

Finalement la figure 6 représente juste un tableau des différentes étapes du procédé de réalisation du circuit intégré selon la présente invention et principalement la structure du cristal de la seconde étape à la cinquième étape ou ultime étape du procédé de réalisation du circuit intégré. Ne sera rien à rajouter de compléments d'information étant donné que les informations présentées dans les figures 5 et 6 sont suffisamment claires pour comprendre l'avantage de la présente invention.

Plusieurs variantes de réalisation du procédé de réalisation du circuit intégré sans défauts ou sans dislocations peuvent être conçues sans sortir du cadre de la portée des revendications présentées.

## Revendications

1. Procédé de réalisation d'un circuit intégré sans défauts ou dislocations au terme du procédé, pour lequel sur au moins un substrat semi-conducteur en silicium (1), il est déposé initialement une première couche (2) d'un composant chimique métallique, et sur cette première couche (2), il est déposé une couche de protection (3) constituée d'un composant chimique principal différent du composant chimique principal de la première couche (2), **caractérisé en ce qu'**il est déposé sur la couche de protection (3), une couche supplémentaire (4) comprenant un composant chimique principal différent ou équivalent ou de dimension équivalente au composant chimique principal de la première couche (2), **en ce que** dans une étape suivante du procédé, il est effectué une opération de traitement thermique à une première température définie pour générer un siliciure (2', 2") constitué du composant principal de la première couche (2) et du silicium (1) selon une première stoechiométrie, **en ce que** dans une étape suivante du procédé, il est effectué le retrait de la couche supplémentaire (4), et de la couche de protection (3) par une opération de gravure humide, et **en ce que** dans une ultime étape du procédé, il est effectué une autre opération de traitement thermique à une température définie plus élevée que la première température afin de changer la stoechiométrie du siliciure précédemment créé.

2. Procédé de réalisation d'un circuit intégré selon la revendication 1, **caractérisé en ce que** la première couche chimique métallique (2), qui comprend du cobalt ou du nickel ou du titane, est déposée sur une face du substrat silicium (1) par un procédé PVD.

3. Procédé de réalisation d'un circuit intégré selon la revendication 1, **caractérisé en ce qu'**il est déposé la première couche chimique métallique (2), qui est composée de cobalt, sur une face du substrat silicium (1) par un procédé PVD.

4. Procédé de réalisation d'un circuit intégré selon la revendication 1, **caractérisé en ce qu'**il est déposé une couche de protection (3), qui est adaptée pour servir de barrière de diffusion.

5. Procédé de réalisation d'un circuit intégré selon la revendication 4, **caractérisé en ce qu'**il est déposé la couche de protection (3), qui est composée de nitrure de titane, sur la première couche (2), qui est composée de cobalt.

6. Procédé de réalisation d'un circuit intégré selon la revendication 1, **caractérisé en ce que** la couche supplémentaire (4) comprend un composant chimique principal équivalent au composé chimique principal de la première couche (2).

7. Procédé de réalisation d'un circuit intégré selon la revendication 1, **caractérisé en ce que** dans une première étape du procédé, il est déposé une première couche (2) d'un composant chimique métallique, qui est du cobalt, sur une face du substrat silicium (1), **en ce qu'**il est déposé la couche de protection (3) en nitrure de titane sur la première couche (2), et **en ce qu'**il est déposé la couche supplémentaire (4) sur la couche de protection (3).

8. Procédé de réalisation d'un circuit intégré selon la revendication 7, **caractérisé en ce qu'**il est déposé la couche supplémentaire (4), comprend du cobalt, sur la couche de protection.

9. Procédé de réalisation d'un circuit intégré selon la revendication 7, **caractérisé en ce que** dans une seconde étape du procédé, il est effectué une première opération de traitement thermique à une première température définie pour générer un siliciure de cobalt (2') selon une première stoechiométrie avec deux atomes de cobalt et un atome de silicium, **en ce que** dans une troisième étape du procédé, il est effectué une seconde opération de traitement thermique à une température équivalente ou supérieure à la première température pour générer un siliciure de cobalt (2") selon une seconde stoechiométrie avec un atome de cobalt et un atome de silicium, **en ce que** dans une quatrième étape du procédé, il est retiré la couche supplémentaire (4), la couche de protection (3) et toute première couche subsistante (2) par une gravure humide, et **en ce que** dans une étape finale du procédé il est effectué un troisième traitement thermique à une température supérieure aux précédentes températures de traitement thermique pour générer un siliciure de cobalt (2"') selon une troisième stoechiométrie avec un atome de cobalt et deux atomes de silicium.

10. Procédé de réalisation d'un circuit intégré selon la revendication 9, **caractérisé en ce que** la première opération de traitement thermique est effectuée à une température de l'ordre de 350°C, **en ce que** la seconde opération de traitement thermique est effectuée à une température de l'ordre de 375°C, et **en ce que** la troisième opération de traitement thermique est effectuée à une température de l'ordre de 550°C.
